Europäisches Patentamt

European Patent Office

Office européen des brevets

(19)

(11) Veröffentlichungsnummer: **0 008 691**
**B1**

(12) # EUROPÄISCHE PATENTSCHRIFT

(45) Veröffentlichungstag der Patentschrift:
07.07.82

(21) Anmeldenummer: **79102846.7**

(22) Anmeldetag: **07.08.79**

(51) Int. Cl.³: **H 01 L 27/10, H 01 L 21/82, H 01 L 21/265, H 01 L 27/06**

(54) **Speicherzelle für eine Eimerkettenschaltung.**

(30) Priorität: **31.08.78 US 938679**

(43) Veröffentlichungstag der Anmeldung:
**19.03.80 Patentblatt 80/6**

(45) Bekanntmachung des Hinweises auf die Patenterteilung:
**07.07.82 Patentblatt 82/27**

(84) Benannte Vertragsstaaten:
**DE FR GB**

(56) Entgegenhaltungen:
**EP-A-0 000 180**
**DE-A-2 508 833**
**FR-A-2 161 003**
**FR-A-2 197 207**
**US-A-3 959 025**

**IEEE TRANSACTIONS ON ELECTRON DEVICES, Band 23, Oktober 1976, New York C.G. SODINI et al. «Enhanced capacitor for one-transistor memory cell», Seiten 1187–1189.**

(73) Patentinhaber: **International Business Machines Corporation, Armonk, N.Y. 10504 (US)**

(72) Erfinder: **Heller, Lawrence Griffith, 25 Wildwood Drive, Essex Junction, VT 05452 (US)**
Erfinder: **Jones, Harry Jordan, High Meadows Rd., Underhill, VT (US)**
Erfinder: **Kotecha, Harish N., 31 Margaret St., Essex Junction, VT 05452 (US)**
Erfinder: **Soderman, Donald Arvid, 2606 Lakevale Drive, Vienna, VA 22180 (US)**

(74) Vertreter: **Böhmer, Hans Erich, Dipl.-Ing., Schönaicher Strasse 220, D-7030 Böblingen (DE)**

## Speicherzelle für eine Eimerkettenschaltung

Die Erfindung betrifft eine Speicherzelle für eine aus einer Reihenschaltung solcher Zellen bestehende sogenannte Eimerkettenschaltung, bestehend aus einem Halbleitersubstrat eines ersten Leitungstyps mit einer Sourcezone vorbestimmter Dicke eines zweiten Leitungstyps für eine erste Zelle, einer mit Abstand von der Sourcezone angeordneten Drainzone des zweiten Leitungstyps für diese Zelle mit einer ersten Dotierungskonzentration und vorgegebener Dicke, ferner mit einer in der ersten Zelle zwischen der Drainzone und der Sourcezone mit Abstand von dieser und unmittelbar an die Drainzone anschliessend angeordneten ersten ionenimplantierten Draizone des zweiten Leitungstyps mit einer zweiten Dotierungskonzentration, die geringer ist als die erstgenannte Dotierungskonzentration und mit einer Dicke, die geringer ist als die Dicke der Source- und der Drainzone sowie mit einer auf der Oberfläche des Substrats über dem Kanal und der ersten ionenimplantatierten Drainzone angeordneten dünnen Isolierschicht, einer auf der Oberfläche des Substrats über Source- und Drainzone liegenden dicken Isolierschicht und einer über der dünnen Isolierschicht liegenden Gateelektrode.

Eine derartige Anordnung ist bereits aus der DE-A-2 508 833 bekannt und soll im folgenden kurz als BBD-Schaltung bezeichnet werden.

Eine solche BBD-Schaltung ist dabei eine Folge von Schalttransistoren, die kapazitive Speicherknotenpunkte miteinander verbinden, wobei die Gateelektroden miteinander abwechselnder Transistoren in der Kette durch nichtüberlappende Taktimpulse angesteuert werden. BBD-Schaltungen lassen sich vorteilhafterweise in Feldeffekttransistor-Technik aufbauen, wodurch einzelne Speicherzellen geschaffen werden, die in Aufbau und Herstellung einfach sind. Ein eine binäre Informationseinheit darstellendes Spannungs-(Ladungs-)Signal wird an der Sourceelektrode der ersten Zellen einer aus Feldeffekttransistoren aufgebauten Kette von derartigen BBD-Zellen eingespeist. Wenn der Taktimpuls an der Gateelektrode der ersten Zelle auftritt, wird damit die Spannung an dem zuvor zurückgestellten Drainknotenpunkt hochgezogen, so dass ein Strom durch den Feldeffekttransistor fliesst, und die binäre Informationseinheit wird nach der zwischen der ersten Zelle und der zweiten Zelle liegenden Speicherkapazität übertragen. Wenn dann der nächste Taktimpuls an der Gateelektrode der zweiten Zelle der sogenannten Eimerkettenschaltung auftritt, dann wird die an dem zwischen der ersten Zelle und der zweiten Zelle liegenden kapazitiven Knotenpunkt eingespeicherte binäre Informationseinheit durch die zweite Zelle hindurch nach dem zwischen der zweiten Zelle und der dritten Zelle liegenden, im Ruhezustand befindlichen kapazitiven Knotenpunkt übertragen.

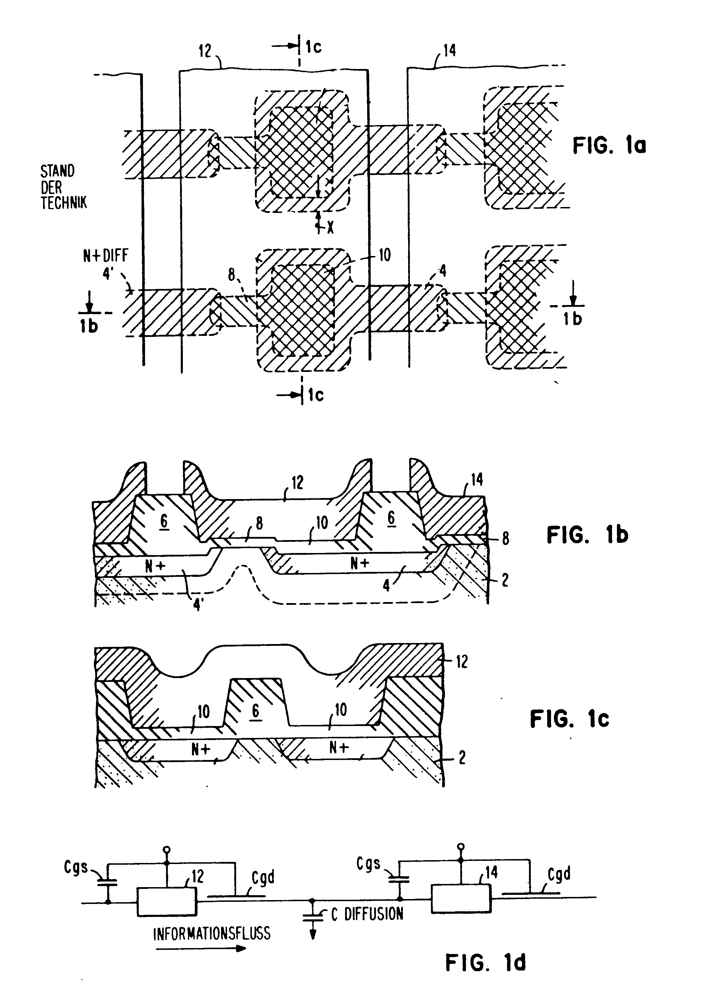

Auf diese Weise kann ein Spannungs-(Ladungs-)Signal über eine Kette derartiger Zellen mit Hilfe von Zwei-Phasen-Taktimpulsen übertragen werden, und man kann damit eine Serienspeicherung, eine Signalübertragung oder Signalverarbeitung durchführen. Dieser Vorgang ist schematisch in Fig. 1d gezeigt. Für jede Ladungsübertragung ist immer eine Zelle vorhanden, die zunächst keine übertragene Ladung aufweist. Diese leere Zelle wird am letzten Transistor einer Kette auf ein Bezugspotential gebracht und wandert im wesentlichen in Gegenrichtung zum Informationsfluss. Somit benötigt man für ein Zwei-Phasen-Taktsignal 2 N Zellen für die Speicherung von N Informationsbits. Die Anzahl der Zellen kann für die Speicherung von N Informationsbits bei Verwendung eines N-phasigen Taktsignals auf

$$\frac{(m)}{m-1} N$$

verringert werden.

Eine erfolgreiche BBD-Zelle muss eine Anzahl von Eigenschaften aufweisen. Da derartige Zellen nicht für sich allein, sondern unter Verwendung einer grossen Anzahl solcher Zellen in Kettenschaltungen eingesetzt werden, muss die einzelne Zelle selbst geringe Abmessungen aufweisen, damit sie sich für die Herstellung für integrierte Schaltungen mit hoher Dichte eignet. Da für viele Anwendungsgebiete lange Ketten derartiger Zellen erforderlich sind, muss der Übertragungswirkungsgrad einer jeden Zelle sehr nahe bei 1 liegen, und der Übertragungswirkungsgrad darf für die Übertragung eines eine binäre 0 darstellenden Signals und eines eine binäre 1 darstellenden Signals nicht verschieden sein.

Ein typisches Beispiel einer solchen in einer sogenannten Eimerkettenschaltung verwendeten Zelle ist in Fig. 1a gezeigt, deren Querschnitt längs der Linie 1b–1b in Fig. 1b gezeigt ist und deren Querschnitt längs der Linie 1c–1c in Fig. 1c zu sehen ist. Die in Fig. 1a bis 1c gezeigte Zelle weist eine metallische Gateelektrode auf, die, obgleich sie nicht als selbst ausgerichtete Gateelektrode aufgebaut ist, ein einfacheres Herstellungsverfahren verwendet als aus polykristallinem Silicium bestehende, selbstausgerichtete Gateelektroden im allgemeinen verwenden, so dass sich eine mehr planare Oberfläche ergibt, auf der photolithographische Verfahren mit grösserer Auflösung durchgeführt werden können. Diese Zelle gemäss dem Stande der Technik wird als Teil einer integrierten Schaltung in einem P-leitenden Substrat 2 gebildet und weist eine $N^+$-leitende Diffusionszone 4 auf, die als kapazitiver Speicherknotenpunkt wirkt. Unter der in Fig. 1b zu sehenden dicken Oxidschicht 6 liegt die Diffusionszone 4', deren rechte Seite als die Sourceelektrode der Zelle Z 12 dient, während deren linke Seite als ein Teil der Drainzone für die links von der Zelle Z 12 liegende Zelle dient. Ganz allgemein gesagt, weist die in Fig. 1b gezeigte Zelle eine dicke Schicht 6 aus Siliciumdioxid auf, die die Gateelektroden 12 und 14 benachbarter Zellen Z12 und Z14 voneinander trennt. Zwischen den dicken Schichten 6 aus Siliciumdioxid befindet sich eine dünnere Schicht aus Siliciumoxid, die aus einem relativ dünneren Abschnitt 8 mit einer Dicke von typischerweise etwa 50 bis 100 Nanometern und einem relativ dickeren Abschnitt 10 mit einer Dicke in der Grössenordnung von 100 bis 150 Nanometern besteht. Das die Gateelektrode 12 bildende Metall der Zelle wird niedergeschlagen und durch photolithographische Verfahren zwischen den dikken Schichten 6 aus Siliciumdioxid über den dünnen Oxidschichten 8 und 10 abgegrenzt. Die unterschiedliche Oxiddicke unterhalb der Gateelektrode 12 eines mit nicht selbstausgerichtetem Gate ausgerüsteten Feldeffekttransistors ist in dem Bereich zwischen den Zonen 6 und 8 der Fig. 1b insofern, wie die Lehre des Standes der Technik darlegt, wünschenswert, als dadurch die parasitäre kapazitive Kopplung zwischen der Gateelektrode 12 und der eindiffundierten Sourcezone 4' verringert wird. Tatsächlich ist es durchaus erwünscht, auf einem mit einer hochintegrierten Halbleiterschaltung versehenen Halbleiterplättchen derartige Zellen vorzusehen, die ihrerseits auch noch zur Durchführung anderer logischer und Eingabe-/Ausgabe-Operationen einsetzbare, mit Ladungsübertragung arbeitende Speicherketten enthalten können. Das aus dem Stand der Technik bekannte Verfahren zum Bilden der dikkeren Zone beruht auf der höheren Oxidationsgeschwindigkeit von stark dotiertem Silicium, wie z.B. die Diffusionszone 4'. Mit diesem Vorteil erkauft man sich jedoch auch den Nachteil, dass über der Diffusionszone 4 eine entsprechend dikkere Oxidschicht 10 gebildet wird, die die Kapazität zwischen der Gateelektrode 12 und der Diffusionszone 4 herabsetzt. Die nachteilige Wirkung stellt sich dabei bei einem FET ein, der als Bauelement in einer mit Ladungsübertragung arbeitenden als sogenannte Eimerkettenschaltung bezeichneten Kettenschaltung verwendet wird, da der Ladungsspeicherknotenpunkt der Zelle, der zwischen Gateelektrode und Diffusionszone gebildet ist, eine verringerte Kapazität je Flächeneinheit aufweist. Der kapazitive Speicherteil einer solchen Zelle liegt im allgemeinen an dem Teil der dünnen Oxidschicht 10, und der durch Feldeffekt schaltende Abschnitt der Zelle ist im allgemeinen im Abschnitt 8 der dünnen Oxidschicht zu finden. Diese aus dem Stand der Technik bekannte Zelle weist daher Nachteile auf, die für den Stand der Technik typisch sind. Im Stand der Technik hat man bisher weder das Problem erkannt noch gelöst, auf dem gleichen, mit integrierter Schaltung versehenen Halbleiterplättchen sowohl Feldeffekttransistoren für logische Schaltungen mit unterschiedlichen Dicken der Oxidschichten als auch für Eimerkettenschaltungen geeignete Bauelemente mit möglichst kleiner Dicke der Siliciumdioxidschicht 10 im kapazitiven Speicherbereich unterzubringen, um damit die Kapazität je Flächeneinheit möglichst hoch zu machen, während gleichzeitig die Dicke der Oxidschicht in Fig. 1b möglichst gross gemacht wird, damit die kapazitive Kopplung zur Sourceelektrode herabgesetzt wird. Die Ladungsübertragung längs einer solchen Kette, die in Fig. 1d gezeigt ist, ist das Ergebnis einer kapazitiven «bootstrap operation», bei der die Grösse der von einem Knotenpunkt zum nächsten übertragenen Ladung eine Funktion der Differenz zwischen der Grösse der Gate-Source-Kapazität $C_{gs}$ und der Gate-Drain-Kapazität $C_{gd}$ ist. Je grösser $C_{gd}$ in bezug auf $C_{gs}$ ist, um so grösser ist die übertragene Ladung. Da für jede Zelle einer Eimerkettenschaltung eine Mindestgrösse der Kapazität erforderlich ist, damit für ein bestimmtes Anwendungsgebiet ein feststellbares Ausgangssignal auftritt, muss wegen dieser Kapazitätsforderung die Fläche der Zelle grösser gemacht werden.

Weitere Schwierigkeiten, wie sie bei einer in Fig. 1a bis 1c gezeigten Zelle des Standes der Technik auftreten, betreffen die Unmöglichkeit, eine Selbstausrichtung der Strukturelemente einer solchen Zelle zu erreichen, so dass der Abstand X, der für eine Ausrichttoleranz zwischen der Diffusionszone 4 und den Ätzgrenzen für das Gateoxid erforderlich ist, den Entwickler dazu zwingen, den trennenden Abstand zwischen benachbarten Ketten derartiger Zellen breiter zu machen. Eine andere Gruppe von Schwierigkeiten, die sich bei den aus dem Stand der Technik bekannten Zellen für sogenannte Eimerkettenschaltungen ergeben, betreffen die die Verkürzung des Kanals bewirkenden Einflüsse, die dann auftreten, wenn benachbarte Zellen in ein und derselben Kette zu eng aneinandergereiht werden.

Wegen der beträchtlichen Tiefe der in Fig. 1b gezeigten Diffusionszone 4 in vertikaler Richtung gegenüber dem Kanalbereich zwischen der Diffusionszone 4 und der Diffusionszone 4' wird mit Verringerung des Abstandes zwischen den Diffusionszonen 4 und 4' die Schwellenwertspannung des den Feldeffekttransistor bildenden Teils der Zelle unterhalb der dünnen Oxidschicht 8 für die Grösse der Spannungsdifferenz zwischen den Diffusionszonen 4 und 4' empfindlich. Das hat zur Folge, dass die Schwellenwertspannung für den Ladungsübertragungswirkungsgrad für binäre 1-Signale sich von dem für binäre 0-Signale unterscheidet. Da die Schwellenwertspannung und der Ladungsübertragungswirkungsgrad vom logischen Wert des zu übertragenden Signals abhängen, bewirken lange Ketten derartiger Zellen eine Verschlechterung des übertragenen Signales, die sich besonders beim ersten unterschiedlichen Bit in einer Folge auswirkt.

Ferner wurde in der EP-A-0 000 180 eine Halbleiterzellenstruktur für eine Eimerkettenschaltung (BBD-Schaltung) vorgeschlagen, welche für jede Speicherzelle eine Kombination aus einem MOS-Kondensator und einem MOS-FET enthält. Dabei ist auf einer Seite der Draindiffusion eine damit verbundene dünne ionenimplantierte Erweiterung der Drainzone vorgesehen, die durch einen kurzen Kanalbereich von der benachbarten Draindiffusionszone getrennt ist. Über dem Kanalbereich und der ionenimplantierten Erweiterung der Drainzone liegt unterhalb der Gateelektrode eine durchgehende dünne Oxidschicht gleichmässiger Dicke. Die Gateelektrode überlappt die Drainzone zum grössten Teil, die Sourcezone dagegen nur zu einem kleinen Teil. Dadurch erhält man eine hohe Gate-Drain-Kapazität je Flächeneinheit.

Aus der US-A-3 959 025 ist ferner eine Halbleiterstruktur bekannt, bei der gering dotierte, durch Ionenimplantation hergestellte Erweiterungen der Source- und Drainzone vorgesehen sind, die zwischen sich einen entgegengesetzt dotierten Kanal einschliessen.

Die Aufgabe der Erfindung besteht somit darin, die Schaltungsdichte einer sogenannten Eimerkettenschaltung der eingangs genannten Art noch weiter zu erhöhen und dabei gleichzeitig die Empfindlichkeit der Schwellenwertspannung und ihre Abhängigkeit von der Grösse der Source-Drain-Spannung zu verringern. Dabei soll ausserdem die Überlappkapazität von Gate nach Drain in der vorgenannten Eimerkettenschaltung möglichst gross gemacht werden.

In Verbindung damit soll es möglich sein, auf den gleichen Halbleiterplättchen sowohl aus FET bestehende logische Schaltungen mit verringerten parasitären Kapazitäten als auch sogenannte Eimerkettenschaltungen unterzubringen, die je Flächeneinheit eine möglichst grosse Gate-Drain-Kapazität aufweisen.

Die der Erfindung zugrundeliegende Aufgabe wird dadurch gelöst, dass unmittelbar anschliessend an die zu der ersten Zelle gehörende erste ionenimplantierte Drainzone des zweiten Leitungstyps mit einer zweiten Dotierungskonzentration eine zweite ionenimplantierte Drainzone des zweiten Leitungstyps mit einer dritten Dotierungskonzentration, die geringer als die zweite Dotierungskonzentration ist, mit einem Abstand von der ersten Sourcezone und einer geringeren Dicke als die erste inonenimplantierte Drainzone vorgesehen ist, so dass die sich ergebende Struktur zwei vereinigte FET-Elemente mit unterschiedlichen Schwellenwerten darstellt, die als Vereinigung eines Ladungsspeicherkondensators mit einem Feldeffekttransistor eine Speicherzelle bildet.

Die Erfindung betrifft auch ein Verfahren zum Herstellen einer derartigen Speicherzelle, bei welchem zunächst auf einem Siliciumsubstrat eines ersten Leitungstyps mit relativ geringer Dotierungskonzentration eine erste aus Siliciumdioxid bestehende Schicht erzeugt und in dieser Schicht eine Anzahl auf Abstand stehender Öffnungen angebracht werden, worauf in jeder dieser Öffnungen durch Diffusion eine Zone des zweiten Leitungstyps mit relativ hoher Störelementkonzentration als Source- oder Drainzone erzeugt wird, bei dem anschliessend eine zweite SiO$_2$-Schicht in den Öffnungen und über der ersten SiO$_2$-Schicht erzeugt wird, worauf in der zweiten SiO$_2$-Schicht eine weitere Anzahl von Gate-Öffnungen, d.h. je eine zwischen benachbarten Source- und Drainzonen hergestellt wird, die jeweils an einer Kante etwa mit der zugewandten Kante der einen Diffusionszone ausgerichtet sind und mit der gegenüberliegenden Kante die angrenzende Kante der anderen benachbarten Diffusionszone überlappen, wobei dann eine Ionenimplantationsmaske zur Abdeckung des source-seitigen Endes einer jeden Diffusionszone und eines Teils jeder sich daran anschliessenden Gate-Öffnung in der Weise aufgebracht wird, dass in jeder Gate-Öffnung anschliessend an das drain-seitige Ende einer jeden Diffusionszone ein Bereich für eine erweiterte Drainzone/Elektrode frei bleibt, dann durch Ionenimplantation durch die frei bleibenden Bereiche der Maske hindurch die erste ionenimplantierte Drainzone erzeugt wird. Dieses Verfahren zeichnet sich erfindungsmäss dadurch aus, dass nach Herstellen der ersten ionenimplantierten Drainzone in Form einer Kondensator-Elektroden/Drainerweiterung zum Abdecken des source-seitigen Endes jeder Diffusionszone und eines Teils der sich daran anschliessenden Gate-Öffnung eine zweite Ionenimplantationsmaske gebildet wird, die den Oberflächenbereich der zweiten ionenimplantierten Drainzone freilegt, dass dann durch Ionenimplantation die zweite ionenimplantierte Drainzone gebildet wird und dass nach Abziehen der zweiten Ionenimplantationsmaske in der Gate-Öffnung eine Gateelektrode gebildet wird.

Die Erfindung wird nunmehr anhand von Ausführungsbeispielen in Verbindung mit den beigefügten Zeichnungen im einzelnen beschrieben. Es zeigen

Fig. 1a eine Draufsicht auf eine in einer sogenannten Eimerkettenschaltung verwendbaren Zelle gemäss dem Stande der Technik, ·

Fig. 1b eine Querschnittsansicht längs der Schnittlinie 1b–1b in Fig. 1a,

Fig. 1c eine Querschnittsansicht längs der Schnittlinie 1c–1c in Fig. 1a,

Fig. 1d ein elektrisches Ersatzschaltbild der in Fig. 1a dargezeigten Kettenschaltung,

Fig. 2a eine Draufsicht auf eine erfindungsgemäss aufgebaute Kettenschaltung zur Darstellung der doppelt implantierten, für eine sogenannte Eimerkettenschaltung verwendbaren Zelle mit einer doppelt implantierten Erweiterung der Drainzone,

Fig. 2b eine Querschnittsansicht längs der Schnittlinie 2b–2b in Fig. 2a,

Fig. 2c eine Schnittansicht längs der Schnittlinie 2c–2c in Fig. 2a,

Fig. 3a–3f eine Folge von Verfahrensschritten zum Herstellen einer erfindungsgemäss aufgebauten Zelle gemäss Fig. 2a,

Fig. 4 Teile eines FET-Kanals mit hoher und niedriger Schwellenwertspannung und einem über einem ionenimplantierten Speicherknotenpunkt gebildeten Bootstrap-Kondensator sowie zwei Zellen, die in einer sogenannten Eimerkettenschaltung hintereinander geschaltet sind,

Fig. 5a–5c die verbesserten Ladungswirkungsgrade der doppelt implantierten Struktur unter Verwendung von Potentialdiagrammen,

Fig. 5d ein Impulsdiagramm für die Ladungsübertragungsfolge in den Fig. 5a–5c und

Fig. 6 eine graphische Darstellung der Verhältnisse zwischen Übertragungsdämpfung je Stufe, aufgetragen über der effektiven Kanallänge für eine doppelt implantierte Zelle gemäss Fig. 2a.

Beschreibung einer bevorzugten Ausführungsform

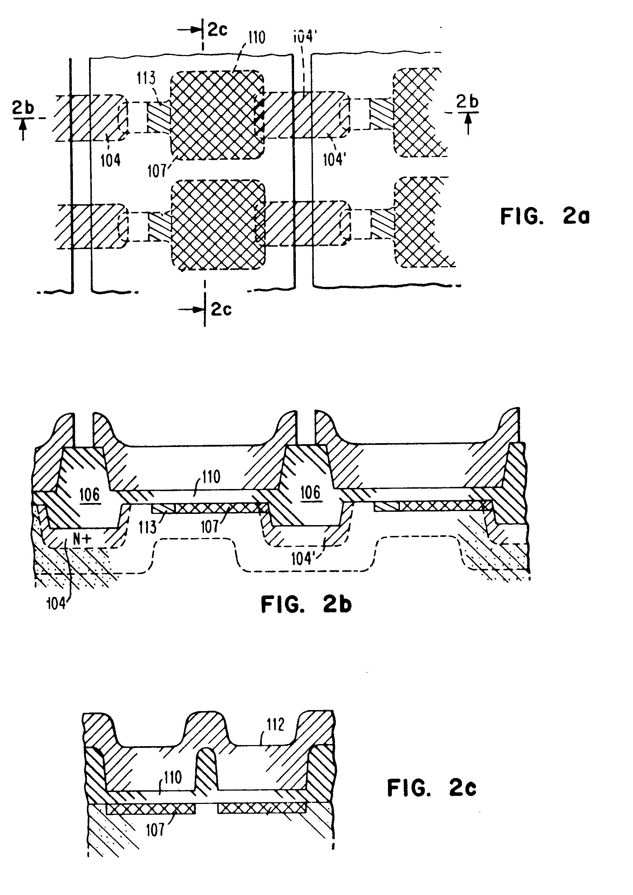

Die Erfindung besteht im Aufbau und im Verfahren zum Herstellen einer Zelle für eine sogenannte Eimerkettenschaltung, die aus einer Vereinigung eines MOS-Kondensators mit einem MOS-FET zur Bildung einer Ladungsübertragungszelle besteht. Zunächst wird eine dünne N-leitende Zone 107 mit einer ersten Konzentration in einem Teil eines P-leitenden Kanalbereichs eines FET anschliessend an die Draindiffusion implantiert. Eine zweite Zone 113 wird mit einem N-Leitfähigkeit hervorrufenden Störelement mit einer zweiten Konzentration, die geringer ist als die erste Konzentration, anschliessend an die erste implantierte Zone implantiert. Die N-leitende Konzentration der zweiten Zone reicht gerade für eine Kompensation der P-leitenden Hintergrunddotierung im Kanalbereich aus. Diese Struktur erhöht den Ladungsübertragungswirkungsgrad für die Zelle und verringert seine Abhängigkeit der Schwellenwertspannung von der Source-Drain-Spannung. Die Gateelektrode des Bauelementes weist eine merkliche Überlappung über die Drainzone und eine nur geringe Überlappung über die Sourcezone auf, und die Gate-Drain-Kapazität je Flächeneinheit wird dadurch zu einem Höchstwert gemacht, dass über der Gatezone eine gleichförmige dünne Oxidschicht beibehalten wird. Die Zellenstruktur für eine doppelt implantierte Zelle gemäss der Erfindung ist in den Fig. 2a bis 2c als Reihenschaltung einer Folge solcher Zellen dargestellt.

Die Zellen werden als Elemente einer integrierten Schaltung in einem P-leitenden Halbleitersubstrat 102 mit einer Dotierung zwischen 7 und $10 \times 10^{15}$ at/cm³ gebildet. Eine Sourcezone vom entgegengesetzten Leitungstyp (N-leitend) wird durch Diffusion von Phosphor oder Arsen in die Oberfläche des Substrats bis zu einer Tiefe von 1 bis 2 Mikrometer hergestellt. Eine zweite ähnliche Sourcezone 104' wird gleichzeitig für eine zweite Zelle dieser Art mit Abstand von der ersten Sourcezone 104 gebildet. Über den Zonen 104 und 104' wird eine dicke Siliciumdioxidschicht 106 bis zu einer Dicke von 800 Nanometern gebildet. Eine dünne Oxidschicht 110 mit einer gleichförmigen Dicke von 50 bis 70 Nanometern wird über dem Halbleitersubstrat 102 im Bereich zwischen den dicken Oxidschichten 106 zur Bildung einer Kettenschaltung solcher Zellen hergestellt.

Ein Teil der dünnen Oxidschicht 110 in jeder Zelle wird einer ersten Ionenimplantation mit Phosphor oder Arsen (133) unterzogen zur Bildung einer Drainelektrode des FET und des Speicherknotenpunkts als einen Beleg des mit einer dünnen Oxidschicht versehenen Bootstrap-Kondensators. Eine Ionendosierung bei der Implantation von gewöhnlich $1–5 \times 10^{13}$/cm² reicht zur Bildung einer N-leitenden Schicht bei weniger als 0,2 µm Tiefe von der Oberfläche aus. Diese implantierte Zone 107 bildet die Drainzone des FET, während die verbleibende dünne Oxidzone zwischen Implantat und Sourcediffusion den FET-Kanal bildet.

Eine zweite Ionenimplantation 135, die die erste Implantation überlappt und sich weiter in den aus der dünnen Oxidschicht bestehenden Kanalbereich des FET hinein erstreckt, weist eine geringere Implantationsdosierung von $0,5–1 \times 10^{12}$/cm² aus Phosphor oder Arsen auf für eine Kompensation der Substratdotierung. Die sich dabei ergebende Struktur besteht aus zwei vereinigten FET-Elementen mit unterschiedlichen Schwellenwertspannungen. Der der Sourcezone am nächsten liegende Bereich hat eine Schwellenwertspannung von rund 1 Volt, während der in der Nähe der implantierten Drainzone 107 liegende Bereich, der der ersten und zweiten Implantation ausgesetzt war, eine niedrige Schwellenwertspannung zwischen 0 und $-1$ Volt aufweist.

Ein Gateleiter 112 liegt über der dünnen Isolierschicht 110 und vervollständigt damit die neue Zellenstruktur.

Die zweite Ionenimplantation kann im übrigen auch an anderen Stellen des die integrierte Schaltung tragenden Halbleiterplättchens für an sich bekannte Feldeffekttransistoren vom Verarmungstyp verwendet werden.

Die durch zweifache Implantation hergestellte Zelle, die aus einer Verbindung eines Speicherkondensators mit einer FET-Struktur entstanden ist, hat mehrere Vorteile:

1. eine Schwellenwertspannung, deren Abhängigkeit vom Source-Drain-Potential verringert ist, so dass sich ein hoher Ladungsübertragungs-Wirkungsgrad ergibt,

2. die Zellenanordnung ist sehr dicht wegen der Überlagerung von Drainzone und dünner Oxidschicht, die als Kondensator wirkt, und

3. die maximale Bootstrap-Kapazität liefert eine grosse Signalladung aus der dünnen Isolierschicht im implantierten Drainbereich und wegen der besonders kleinen parasitären Kapazität der dickeren Schichten über den diffundierten Zonen.

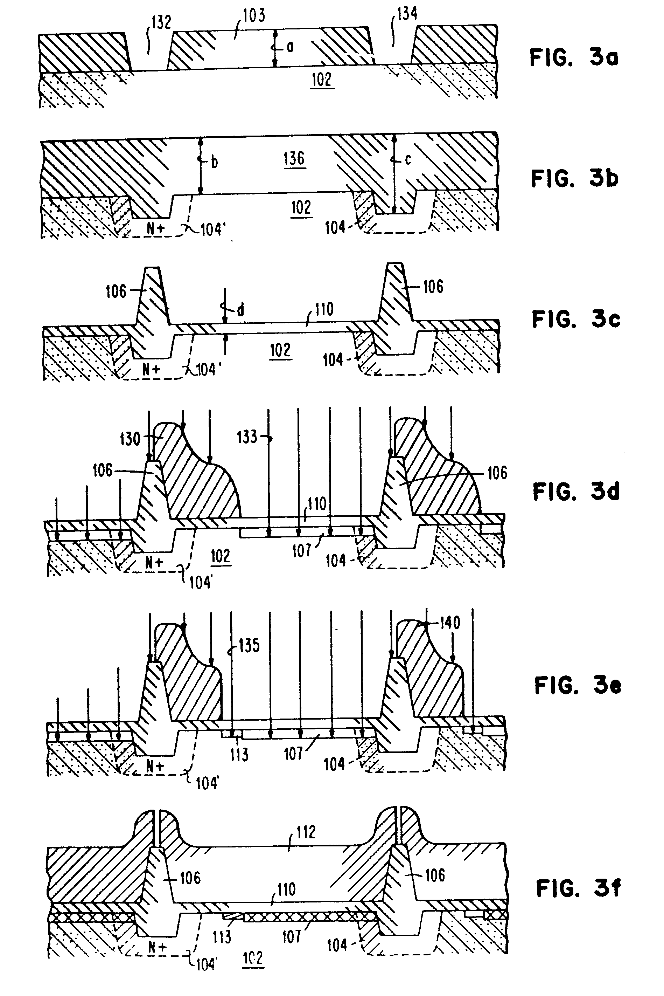

Das Verfahren zum Herstellen der in Fig. 2a bis 2c gezeigten Zelle ist in den Fig. 3a bis 3c und 3e bis 3f dargestellt.

Zunächst beginnt man damit, dass man ein P-leitendes Siliciumsubstrat 102 mit angenähert 1,5 Ohm-Zentimeter (Dotierkonzentration zwischen 7 und $10 \times 10^{15}$/cm²) verwendet und darauf in einem üblichen thermischen Oxidationsverfahren eine erste Oxidschicht 103 mit einer Dicke von 300 Nanometern niederschlägt, die in Fig. 3a mit a bezeichnet ist. Öffnungen 132 und 134 werden dann in die Oxidschicht 103 geätzt. Anschliessend werden durch Niederschlagen von Phosphorsilikatglas 136 über der thermisch gebildeten Oxidschicht 103 und den freiliegenden Öffnungen 132 und 134 die Sourcediffusionen 104 und 104' bei einer Temperatur von 870 °C für angenähert 25 Minuten gebildet. Ein Source-Drain-Eintreibzyklus von etwa 250 Minuten Dauer in Wasserdampf von 900 °C ergibt eine Schicht aus Phosphorsilikatglas über Sourcezonen 104 und 104' mit einer Dicke von 950 Nanometern, mit c bezeichnet, und eine 750 Nanometer dicke Schicht aus Siliciumdioxid über den verbleibenden Bereichen, mit b bezeichnet, wodurch sich eine nahezu ebene Oberfläche aus Phosphorsilikatglas und Siliciumdioxid ergibt, wie dies Fig. 3b zeigt.

Anschliessend wird ein Photo-Oxid-Ätzschritt zur Bildung von Öffnungen in den dicken Oxidbereichen zwischen benachbarten diffundierten Zonen eingesetzt. Dabei wird absichtlich eine gewisse Überlappung dieser Öffnungen über den Diffusionsbereichen benutzt und damit eine Kontinuität zwischen Diffusionszone und dem aus einer dünnen Oxidschicht bestehenden FET-Kanal eingeführt, um damit die Ausrichtung und die Toleranzen für verschiedene Photolackmasken und Masken zu berücksichtigen. Diese Überlappung der Sourcediffusionszone definiert die parasitäre Kapazität $C_{gs}$. Der nächste Schritt besteht in der Herstellung einer weiteren Oxidschicht, durch eine trockene Oxidation für 250 Minuten bei 900 °C und anschliessend durch Niederschlag von Phosphorsilikatglas für 10 Minuten bei 850 °C, worauf die Struktur bei 1000 °C für 20 Minuten zur Bildung einer dünnen Oxidschicht 110 von 50 Nanometer Dicke, in Fig. 3c mit d bezeichnet, angelassen wird.

Als nächstes wird über einem Teil der dünnen Oxidschicht 110 und dem Teil der benachbarten dicken Oxidschicht 106, wie in Fig. 3d gezeigt, eine Photolackschicht 130 niedergeschlagen, die als Ionenimplantationsmaske für die Implantation 133 von Phosphorionen bei 65 KeV dienen soll. Für eine dünne Oxidschicht 110 mit einer Dicke von 50 Nanometern bringt eine Beschiessung mit einem Ionenstrahl bei 65 KeV und einer Dosierung von $10^{13}/cm^2$ eine N-leitende Erweiterung 107 der Drainzone. Dies ist die Erweiterung der Drainzone, und sie dient als kapazitiver Speicherknotenpunkt für die Zelle. Für einen Bootstrap-Kondensator mit 25 Femtofarad und einer typischen 100fC Signalladung nimmt diese Erweiterung der Drainzone eine Fläche von $5 \times 6$ µm ein.

Nach Entfernung der ersten Ionenimplantationsmaske wird eine zweite Photolack-Ionenimplantationsmaske 140 gebildet, die eine grössere Fläche der dünnen Oxidschicht gemäss Fig. 3e freilegt. Diese zweite Ionenimplantation überlappt die Drainerweiterung und gibt zusätzliche 2–4 µm des verbleibenden dünnen Oxidkanals zwischen Diffusionszone und Drainimplantation frei.

Fig. 3e zeigt die zweite Ionenimplantation von Phosphor 135 und des Teils mit niedrigem Schwellenwert des FET-Kanals.

Die Dosierung der zweiten Ionenimplantation ist wesentlich geringer als die der ersten, so dass die Zone 113 eine selektiv umkehrbare Drainerweiterung bildet.

Nach Entfernen der zweiten Maske und Bilden einer Gateelektrode in der Öffnung wird auf diese Weise gemäss Fig. 3f eine doppelt implantierte, für eine sogenannte Eimerkettenschaltung geeignete Zelle gebildet.

Die letzten in Fig. 3f gezeigten Verfahrensschritte der Photo-Oxidätzung für Kontakte und das Niederschlagen der metallischen Gateelektroden 112 aus einer Aluminium-Kupfer-Legierung und das Ätzen der Metallisierung vervollständigt das Verfahren.

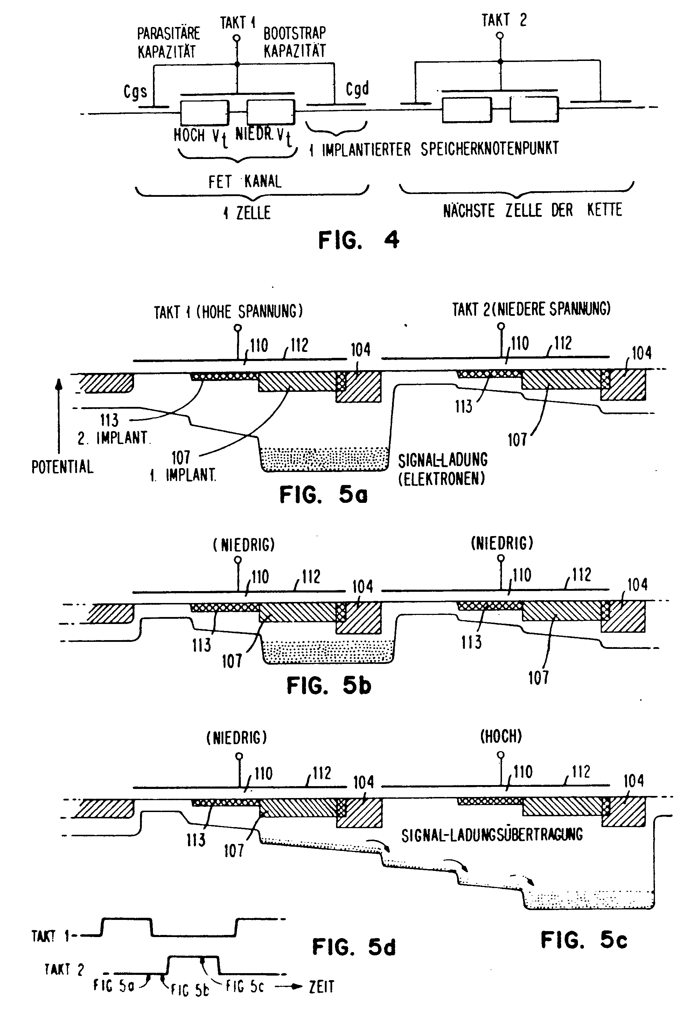

Diese durch zweifache Ionenimplantation entstandene Struktur und das neue Verfahren ergibt eine wesentliche Verbesserung in der Arbeitsweise einer als Schieberegister eingesetzten sogenannten Eimerkettenschaltung. Gegenüber der einfach implantierten Struktur gemäss der Europäischen Patentanmeldung 78 100 214.2 ergibt sich eine höhere Anordnungsdichte wegen der N-leitenden Erweiterung der Drainzone, die mit dem Bootstrap-Kondensator und seiner dünnen Oxidschicht ausgerichtet ist. Der Übertragungswirkungsgrad wird ferner durch die geringe Tiefe der Erweiterung der Drainzone verbessert, was zur Folge hat, dass sich eine geringere Kurz-Kanal-Modulation der Schwellenwertspannung mit der Drainspannung ergibt. Zusätzlich dazu liefert diese neue, durch zweifache Ionenimplantation erzielte Struktur einen wesentlich besseren Ladungsübertragungswirkungsgrad wegen einer noch weiter verringerten Schwankung der Schwellenwertspannung der kombinierten Teile des FET-Kanals mit hoher und niedriger Schwellenwertspannung, welche, wie in Fig. 4 dargestellt, als zwei in Reihe geschaltete Feldeffekttransistoren dargestellt werden können. Bei hohen Drainspannungen wird der Teil des Kanals mit niedrigem Schwellenwert Vt verarmen und der grösste Teil der Source-Drain-Spannung fällt wie beim normalen Abschnüreffekt über diesem Teil ab (Sättigungsbetrieb). Dadurch wird die Schwellenwertspannung für die miteinander verbundenen FETs durch den Teil des Kanals mit hohem Schwellenwert Vt bestimmt. Somit übt jede Änderung in der Source-Drain-Spannung keine merkliche Wirkung auf die gesamte Länge des Kanals und den Schwellenwert aus, wie dies bei Feldeffekttransistoren mit gleichförmigem Kanal der Fall ist, und zwar durch die bekannte spannungsinduzierte Verkürzung des Kanals und die Auswirkung eines kurzen Kanals.

Fig. 5 zeigt eine weitere Darstellung des verbesserten Ladungsübertragungswirkungsgrades mit einer doppelt implantierten Zelle in einer Eimerkettenschaltung. Die Potentialdiagramme von zwei Zellen werden zu verschiedenen Zeitpunkten einer Ladungsübertragungsfolge in den Fig. 5a bis 5c für nichtüberlappende 2 Takt-Phasen (Fig. 5d) gezeigt. Wenn zu Beginn in Fig. 5a der Taktimpuls 1 auf einem hohen Wert liegt, dann ist die Signalladung (Elektronen) in dem hohen Potential in der implantierten Drainerweiterung und dem N-leitenden diffundierten Bereich konzentriert. Während des Übertragungsverfahrens nimmt die Spannung des Taktimpulses 1 ab (Fig. 5b), wodurch Potential der Signalladung absinkt. Der Teil des FET-Kanals mit hohem Schwellenwert wirkt als Sperrschicht und verhindert, dass die Ladung in die vorhergehende Zelle überläuft. Wenn der Taktimpuls 2 auf hohem Potential ist (Fig. 5c), dann wird in der Erweiterung der Drainzone dieser zweiten Zelle der sogenannten Eimerkettenschaltung eine tiefe Potentialquelle gebildet und der Teil des Kanals mit hohem Schwellenwert wird reduziert, so dass die Signalladung nach dieser nächsten Zelle weiterlaufen kann. Für einen hohen Übertragungswirkungsgrad ist es erwünscht, diesen Sperrbereich so schmal wie möglich zu halten, dass unabhängig vom Source-Drain-Potential die gesamte Signalladung diffundieren und in die nächste Zelle weiterwandern kann. Jedoch kann die gut bekannte Kanallängenmodulation und die Wirkung eines kurzen Kanals auf die Schwellenwertspannung eine unvollständige Ladungsübertragung bei üblichen Zellen mit gleichförmigem Kanal zur Folge haben. Diese Abhängigkeit wird durch die zweifach implantierte Struktur im wesentlichen verringert und ermöglicht es, wie Fig. 5c zeigt, dass die Signalladung in mehreren kleineren Schritten mit einem wesentlich konstanteren Gradienten übergeht, wodurch die Möglichkeit, dass Restladungen in einer Ecke der vorhergehenden Zelle hängenbleiben, verringert wird.

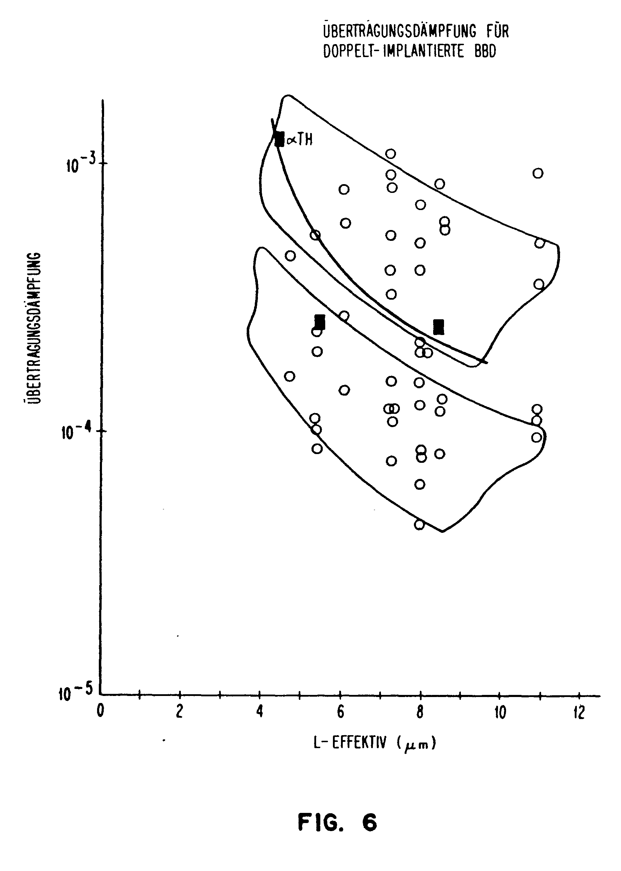

Fig. 6 ist eine graphische Darstellung der Beziehung zwischen der Übertragungsdämpfung je Stufe bei einer niedrigen Frequenz (100 kHz) gegenüber der wirksamen Kanallänge L-effektiv für eine doppelt implantierte Zelle gemäss der Erfindung. Diese Übertragungsdämpfung befindet sich in vernünftiger Übereinstimmung mit der (αten) Dämpfung, berechnet aus einer gemessenen Veränderung der Schwellenwertspannung mit der Drain-Source-Spannung, wenn im Sättigungsbetrieb gearbeitet wird. Der Gradient im Potential über der Doppel-FET-Struktur verbessert den Übertragungswirkungsgrad ebenfalls bei hohen Frequenzen. Mit dem für guten Übertragungswirkungsgrad bei niedrigen Frequenzen erforderlichen kürzeren Teil des Kanals mit hoher Schwellenwertspannung wird die Leitfähigkeit (Konduktanz) durch den FET-Kanal erhöht, was auch die Geschwindigkeit der Ladungsübertragung für guten Wirkungsgrad bei höheren Betriebsfrequenzen erhöht.

## Patentansprüche

1. Speicherzelle für eine aus einer Reihenschaltung solcher Zellen bestehende sogenannte Eimerkettenschaltung, bestehend aus einem Halbleitersubstrat (102) eines ersten Leitungstyps mit einer Sourcezone (104') vorbestimmter Dicke eines zweiten Leitungstyps für eine erste Zelle, einer mit Abstand von der Sourcezone angeordneten Drainzone (104) des zweiten Leitungstyps für diese Zelle mit einer ersten Dotierungskonzentration und vorgegebener Dicke, ferner mit einer in der ersten Zelle zwischen der Drainzone und der Sourcezone mit Abstand von dieser und unmittelbar an die Drainzone anschliessend angeordneten ersten ionenimplantierten Drainzone (107) des zweiten Leitungstyps mit einer zweiten Dotierungskonzentration, die geringer ist, als die erstgenannte Dotierungskonzentration und mit einer Dicke, die geringer ist als die Dicke der Source- und der Drainzone sowie mit einer auf der Oberfläche des Substrats (2) über dem Kanal und der ersten ionenimplantierten Drainzone (107) angeordneten dünnen Isolierschicht (110), einer auf der Oberfläche des Substrats über Source- und Drainzone (104) liegenden dicken Isolierschicht (106) und einer über der dünnen Isolierschicht (110) liegenden Gateelektrode (112), dadurch gekennzeichnet, dass unmittelbar anschliessend an die zu der ersten Zelle gehörende erste ionenimplantierte Drainzone (107) des zweiten Leitungstyps mit einer zweiten Dotierungskonzentration eine zweite ionenimplantierte Drainzone (113) des zweiten Leitungstyps mit einer dritten Dotierungskonzentration, die geringer als die zweite Dotierungskonzentration ist, mit einem Abstand von der ersten Sourcezone und einer geringeren Dicke als die erste ionenimplantierte Drainzone vorgesehen ist, so dass die sich ergebende Struktur zwei vereinigte FET-Elemente mit unterschiedlichen Schwellenwerten darstellt, die als Vereinigung eines Ladungsspeicherkondensators mit einem Feldeffekttransistor eine Speicherzelle bilden.

2. Verfahren zum Herstellen einer Speicherzelle nach Anspruch 1, bei welchem zunächst auf einem Siliciumsubstrat eines ersten Leitungstyps mit relativ geringer Dotierungskonzentration eine erste aus Siliciumdioxid bestehende Schicht erzeugt und in dieser Schicht eine Anzahl auf Abstand stehender Öffnungen angebracht werden, worauf in jeder dieser Öffnungen durch Diffusion eine Zone des zweiten Leitungstyps mit relativ hoher Störelementkonzentration als Source- oder Drainzone (104, 104') erzeugt wird, bei dem anschliessend eine zweite SiO₂-Schicht (136) in den Öffnungen (132, 134) und über der ersten SiO₂-Schicht erzeugt wird, worauf in der zweiten SiO₂-Schicht (136) eine weitere Anzahl von Gate-Öffnungen, d.h. je eine zwischen benachbarten Source–und Drainzonen (104, 104') hergestellt wird, die jeweils an einer Kante etwa mit der zugewandten Kante der einen Diffusionszone ausgerichtet sind und mit der gegenüberliegenden Kante die angrenzende Kante der anderen benachbarten Diffusionszone überlappen, wobei dann eine Ionenimplantationsmaske (130) zur Abdeckung des source-seitigen Endes einer jeden Diffusionszone und eines Teils jeder sich daran anschliessenden Gate-Öffnung in der Weise aufgebracht wird, dass in jeder Gate-Öffnung anschliessend an das drain-seitige Ende einer jeden Diffusionszone ein Bereich für eine erweiterte Drainzone/Elektrode frei bleibt, dann durch Ionenimplantation durch die frei bleibenden Bereiche der Maske hindurch die erste ionenimplantierte Drainzone (107) erzeugt wird, dadurch gekennzeichnet, dass nach Herstellen der ersten ionenimplantierten Drainzone in Form einer Kondensator-Elektorden/Drainerweiterung zum Abdecken des source-seitigen Endes jeder Diffusionszone (104, 104') und eines Teils der sich daran anschliessenden Gate-Öffnung eine zweite Ionenimplantationsmaske (140) gebildet wird, die den Oberflächenbereich der zweiten ionenimplantierten Drainzone (113) freilegt, dass dann durch Ionenimplantation die zweite ionenimplantierte Drainzone (113) gebildet wird, und dass nach Abziehen der zweiten Ionenimplantationsmaske (140) in der Gate-Öffnung eine Gateelektrode (112) gebildet wird.

### Claims

1. A storage cell for a so-called bucket brigade device having a serially connected sequence of such cells, comprising a semiconductor substrate (102) of a first conductivity type with a source region (104') for a first cell, of a second conductivity type having a predetermined thickness, a drain region (104) for this cell, of the second conductivity type, spaced from the source region, having a first dopant concentration and a predeterminde thickness, also comprising a first ion-implanted drain region (107) for the first cell, of the second conductivity type having a second dopant concentration less than the first dopant concentration and a thickness less than the thickness of the source and the drain region, located between the drain region and the source region, spaced therefrom and immediately adjacent to the drain region, as well as with a thin insulating layer (110) lying on the surface of the substrate (2) over the channel and the first ionimplanted drain region (107), a thick insulating layer (106) lying on the surface of the substrate over the source and the drain region (104), and a gate electrode (112) lying over the thin insulating layer (110), characterized in that immediately adjacent to the first ion-implanted drain region (107) for the first cell, of the second conductivity type having a second dopant concentration, there is a second ion-implanted drain region (113) of the second conductivity tpye having a third dopant concentration less thant the second dopant concentration, said second ion-implanted drain region being spaced from the first source region and having a thickness less than the first ion-implanted drain region, so that the resultant structure constitutes two combined FET elements with different threshold values, which as a combination of a charge storage capacitor with a field-effect transistor form a storage cell.

2. A process for making a storage cell according to claim 1, wherein initially a first layer consisting of silicon dioxide is generated on a silicon substrate of a first conductivity type having a relatively low dopant concentration, forming a plurality of windows spaced from one another in this layer, wherein a region of the second conductivity type with a relatively high dopant concentration is then diffused as a source or drain region (104, 104') through each of these windows, wherein subsequently a second $SiO_2$ layer (136) overlying the first $SiO_2$ layer is generated in the windows (132, 134), wherein in the second $SiO_2$ layer (136) a further plurality of gate windows are formed, i.e., one window between adjacent source and drain regions (104, 104'), each one being aligned with the approximate edge of one diffusion region on one edge and overlapping the other adjacent diffusion region on the opposite edge, wherein an ion implantation mask (130) for covering the source side of each diffusion region and a portion of each adjacent gate window is formed in such a manner that a drain/electrode extension region is exposed in each gate window adjacent to the drain side of each diffusion, wherein the first ionimplanted drain region (107) is formed by ion implantation through the exposed regions of the mask, characterized in that after the first ion-implanted drain region in the form of a capacitor/electrode drain extension has been formed for covering the source side of each diffusion region (104, 104') and a portion of the adjacent gate window, a second ion implantation mask (140) is formed, exposing the surface region of the second ion-implanted drain region (113), that the second ion-implatned drain region (113) is then formed by ion implantation, and that after removal of the second ion implantation mask (140), a gate electrode (112) is formed in the gate window.

### Revendications

1. Cellule de mémoire pour un circuit dit à chaîne de seaux composé de cellules montées en série, qui est constitué par un substrat semiconducteur (102) d'un premier type de conductivité comportant une région de source (104') d'une épaisseur prédéterminée d'un second type de conductivité pur une première cellule, une région de drain (104) du second type de conductivité pour cette cellule espacée de la région de source et ayant und première concentration de dopage et une 'épaisseur prédéterminée, und première région de drain à implantation ionique (107) du second type de conductivité, disposée dans la première cellule entre la région de drain et la région de source, espacée de celle-ci et immédiatement adjacente à la région de drain et ayant une seconde concentration de dopage plus faible que la première concentration de dopage mentionnée et une épaisseur plus petite que l'épaisseur de la région de source et de drain, une couche isolante mince (110), disposée sur la surface du substrat (2) au-dessus du canal et de la première région de draint à implantation ionique (107), une couche isolante épaisse (106) déposée sur la surface du substrat au-dessus de la région de source et de drain (104), et une électrode de porte (112) disposée au-dessus de la couche isolante mince (110), caractérisée en ce que, immédiatement adjacente à la région de drain à implantation ionique (107) du second type de conductivité appartenant à la première cellule et ayant une seconde concentration de dopage, il est prévu une région de drain à implantation ionique (113) du second type de conductivité avec une troisième concentration de dopage plus faible que la seconde concentration de dopage, espacée de la première région de source et ayant une épaisseur plus petite que la première région de drain à implantation ionique, de telle sorte que la structure qui en résulte représente deux éléments FET combinés avec différentes valeurs de seuil qui forment une cellule de mémoire en tant que combinaison d'un condensateur de mémoire de charge et d'un transistor à effet de champ.

2. Procédé pour fabriquer une cellule de mémoire selon la revendication 1, dans lequel on produit d'abord sur un substrat de silicium d'un premier type de conductivité avec une concentration de dopage relativement faible une première couche de dioxyde de silicium et dans cette couche un certain nombre d'ouvertures espacées; on forme dans chacune des ces ouvertures par diffusion une région du second type de conductivité avec une concentration d'impureté relativement élevée servant de région de source ou de drain (104, 104′), on dépose ensuite une seconde couche de SiO₂ (136) dans les ouvertures (132, 134) et au-dessus de la première couche de SiO₂, et on forme ensuite dans la seconde couche de SiO₂ (136) d'autres ouvertures de porte, c'est-à-dire une ouverture entre les régions de source et de drain adjacentes (104, 104′) dont un bord est à peu près aligné avec le bord de l'une des régions de diffusion et dont le bord opposé chevauche le bord adjacent de l'autre région de diffusion, un masque d'implantation ionique (130) pour recouvrir l'extrémité du côté source de chaque région de diffusion et une partie de chaque ouverture de porte adjacente étant déposée de telle sorte qu'une zone pour une région d'extension de drain/électode est exposée dans chaque ouverture de porte adjacente à l'extrémité du côté drain de chaque région de diffusion, et en formant ensuite par implantation ionique à travers les régions exposées du masque la première région de drain à implantation ionique (107), caractérisé en ce que, après la réalisation de la première région de drain à implantation ionique sous la forme d'un condensateur électrode/extension de drain pour recouvrir l'extrémité du côté source de chaque région de diffusion (104, 104′) et une partie de l'ouverture de porte adjacente, on forme un second masque d'implantation ionique (140) qui expose la région de surface de la seconde région de drain à implantation ionique (113), en ce qu'on forme la seconde région de drain à implantation ionique (113) par implantation ionique, et en ce qu'on forme dans l'ouverture de porte une électrode de porte (112) après avoir enlevé le second masque d'implantation ionique.

FIG. 1a

STAND DER TECHNIK

FIG. 1b

FIG. 1c

FIG. 1d

FIG. 2a

FIG. 2b

FIG. 2c

FIG. 3a

FIG. 3b

FIG. 3c

FIG. 3d

FIG. 3e

FIG. 3f

0 008 691

PARASITÄRE KAPAZITÄT    TAKT 1    BOOTSTRAP KAPAZITÄT    TAKT 2

Cgs    Cgd

HOCH $V_t$    NIEDR. $V_t$    1 IMPLANTIERTER SPEICHERKNOTENPUNKT

FET KANAL

1 ZELLE    NÄCHSTE ZELLE DER KETTE

FIG. 4

TAKT 1 (HOHE SPANNUNG)    TAKT 2 (NIEDERE SPANNUNG)

110   112   104    110   112   104

113

113   2. IMPLANT.

POTENTIAL    107   1. IMPLANT.    107

SIGNAL-LADUNG (ELEKTRONEN)

FIG. 5a

(NIEDRIG)    (NIEDRIG)

110   112   104    110   112   104

113   107    113   107

FIG. 5b

(NIEDRIG)    (HOCH)

110   112   104    110   112   104

113   107    SIGNAL-LADUNGSÜBERTRAGUNG

TAKT 1

TAKT 2   FIG 5a   FIG 5b   FIG 5c  → ZEIT

FIG. 5d      FIG. 5c

17

ÜBERTRAGUNGSDÄMPFUNG FÜR
DOPPELT-IMPLANTIERTE BBD

FIG. 6